# EUROPÄISCHE PATENTANMELDUNG

(11) **EP 4 293 793 A2**
(43) Veröffentlichungstag der Anmeldung: **20.12.2023**
(21) Anmeldenummer: 23171835.4
(22) Anmeldetag: 05.05.2023
(51) Int. Cl.: H01M 10/42, H01M 8/04313, H01M 10/48

(54) **ELEKTROCHEMIEZELLEN-ÜBERWACHUNGSVORRICHTUNG, ELEKTROCHEMIEZELLEN-ÜBERWACHUNGSSYSTEM UND VERFAHREN**

(30) Priorität: 18.05.2022 DE 102022112494
(71) Anmelder: H-TEC SYSTEMS GmbH, 86153 Augsburg (DE)
(72) Erfinder: Bülow, Norbert, 23560 Lübek (DE); Mantai, Nils, 23562 Lübeck (DE)
(74) Vertreter: Schlosser, Stefan

(57) **Zusammenfassung**

Die Erfindung geht aus von einer Elektrochemiezellen-Überwachungsvorrichtung (38a; 38b), insbesondere einer Elektrolysezellen-, Brennstoffzellen- und/oder Batteriezellenüberwachungsvorrichtung, mit zumindest einem Anzeigemodul (10a; 10b), welches zumindest ein Anzeigeelement (12a; 12b) aufweist, das dazu vorgesehen ist, zumindest eine Information über zumindest einen Funktionsparameter einer Elektrochemiezelle (14a; 14b) in Form elektromagnetischer Strahlung auszugeben.

Es wird vorgeschlagen, dass die Elektrochemiezellen-Überwachungsvorrichtung (38a; 38b) zumindest eine, insbesondere getrennt und beabstandet von dem Anzeigemodul (10a; 10b) angeordnete, optische Sensoreinheit (16a; 16b) aufweist, welche dazu vorgesehen ist, die elektromagnetische Strahlung zumindest des Anzeigeelements (12a; 12b) zu detektieren und aus der detektierten elektromagnetischen Strahlung zumindest die Information über den zumindest einen Funktionsparameter der Elektrochemiezelle (14a; 14b) auszulesen

## Beschreibung

### Stand der Technik

Die Erfindung betrifft eine Elektrochemiezellen-Überwachungsvorrichtung nach dem Oberbegriff des Anspruchs 1, ein Elektrochemiezellen-Überwachungssystem nach dem Anspruch 11, ein Verfahren zur Überwachung einer Elektrochemiezelle nach dem Oberbegriff des Anspruchs 16 und ein Verfahren zur Kalibration des Elektrochemiezellen-Überwachungssystems nach dem Oberbegriff des Anspruchs 17.

In der EP 3 612 664 A1 ist bereits vorgeschlagen worden, dass Einzelzellspannungen von Elektrolyseuren über elektrische Kontakte abgegriffen werden. Diese werden dann i.d.R. über Kabelverbindungen mit zentralen Computerüberwachungssystemen von Elektrolyseanlagen verbunden.

Die Aufgabe der Erfindung besteht insbesondere darin, eine gattungsgemäße Vorrichtung mit vorteilhaften Eigenschaften hinsichtlich einer Effizienz bereitzustellen. Die Aufgabe wird erfindungsgemäß durch die Merkmale der Patentansprüche 1, 11, 16 und 17 gelöst, während vorteilhafte Ausgestaltungen und Weiterbildungen der Erfindung den Unteransprüchen entnommen werden können.

### Vorteile der Erfindung

Die Erfindung geht aus von einer Elektrochemiezellen-Überwachungsvorrichtung, insbesondere Elektrolysezellen-, Brennstoffzellen- und/oder Batteriezellenüberwachungsvorrichtung, mit zumindest einem Anzeigemodul, welches zumindest ein Anzeigeelement aufweist, das dazu vorgesehen ist, zumindest eine Information über zumindest einen Funktionsparameter einer Elektrochemiezelle in Form elektromagnetischer Strahlung auszugeben.

Es wird vorgeschlagen, dass die Elektrochemiezellen-Überwachungsvorrichtung zumindest eine, insbesondere getrennt und beabstandet von dem Anzeigemodul angeordnete, optische Sensoreinheit aufweist, welche dazu vorgesehen ist, die elektromagnetische Strahlung zumindest des Anzeigeelements zu detektieren und aus der detektierten elektromagnetischen Strahlung zumindest die Information über den zumindest einen Funktionsparameter der Elektrochemiezelle auszulesen. Dadurch kann vorteilhaft eine hohe Effizienz erreicht werden, insbesondere hinsichtlich Kosten und/oder Materialbedarf. Insbesondere da Elektrochemiezellen wie Elektrolysestacks oft aus einer Vielzahl an Einzelzellen bestehen, kann vorteilhaft eine notwendige Gesamtkabellänge (Kabelanzahl und Kabellänge) wesentlich reduziert werden. Außerdem kann vorteilhaft ein Nutzerkomfort wesentlich gesteigert werden, insbesondere durch eine bessere Übersichtlichkeit und/oder eine verbesserte Handhabung. Vorteilhaft ist wesentlich weniger Elektronik, insbesondere wesentlich weniger Auswerteeinheiten notwendig, da durch die vorgeschlagene Elektrochemiezellen-Überwachungsvorrichtung eine Vielzahl an einzelnen Spannungsmessern ersetzt werden kann. Vorteilhaft kann eine kompaktere Ausbildung der die Elektrochemiezellen beinhaltenden Anlage ermöglicht werden. Zudem kann vorteilhaft eine zumindest grobe Lageeinschätzung bereits ohne Auswerteelektronik und nur mittels eines Blicks auf das Anzeigemodul ermöglicht werden. Die Elektrochemiezellen-Überwachungsvorrichtung ist insbesondere ein Teil einer Elektrochemieeinheit, beispielsweise eines Elektrolysestacks, eines Elektrolyseurs, einer Batterie, eines Batteriesystems, einer Brennstoffzelle oder dergleichen. Vorzugsweise ist die Elektrochemieeinheit als eine Wasserstoffelektrolysevorrichtung ausgebildet, die insbesondere zur elektrochemischen Spaltung von Wasser in Wasserstoff und Sauerstoff vorgesehen ist. Die Elektrochemievorrichtung kann dazu vorgesehen sein, zumindest ein Gas, insbesondere Wasserstoff, mit einem Überdruck gegenüber einer Umgebung bereitzustellen. Die Elektrochemiezellen-Überwachungsvorrichtung ist insbesondere dazu vorgesehen, einen Betriebszustand, vorzugsweise den Funktionsparameter, der Elektrochemieeinheit, vorzugsweise während eines Betriebs der Elektrochemieeinheit zu überwachen. Vorzugsweise ist die Elektrochemiezellen-Überwachungsvorrichtung zumindest dazu vorgesehen, Fehlerbetriebszustände und/oder Betriebszustände außerhalb eines optimalen Betriebsbereichs zu erkennen. Insbesondere ist die Elektrochemiezellen-Überwachungsvorrichtung zumindest dazu vorgesehen, einen oder mehrere Funktionsparameter aufzuzeichnen. Insbesondere ist die Elektrochemiezellen-Überwachungsvorrichtung zu einer Sicherheits- und/oder Qualitätsüberwachung der Elektrochemieeinheit, insbesondere mittels der Ermittlung von Einzelzellspannungen von Elektrochemiezellen, vorgesehen. Beispielsweise ist die Elektrochemiezellen-Überwachungsvorrichtung zu einer Erkennung von Kurzschlüssen und/oder von Alterungserscheinungen der Elektrochemiezellen, vorgesehen. Unter einer "elektromagnetischen Strahlung" soll insbesondere sichtbares Licht und/oder Infrarotlicht und/oder Nahinfrarotlicht verstanden werden. Vorzugsweise ist die optische Sensoreinheit mindestens einen Meter, vorzugsweise mindestens fünf Meter und bevorzugt mindestens zehn Meter von dem Anzeigemodul entfernt angeordnet. Insbesondere umfasst die optische Sensoreinheit zumindest einen Sensor, welcher empfindlich ist für das Spektrum, welches von dem Anzeigeelement für alle möglichen Funktionsparameter ausgebbar ist. Vorzugsweise umfasst die Sensoreinheit zumindest einen für Infrarotlicht und/oder für sichtbares Licht empfindlichen Sensor. Bevorzugt umfasst die Sensoreinheit eine Infrarotkamera, eine Kamera für sichtbares Licht und/oder eine Multi- oder Hyperspektralkamera. Insbesondere umfasst die Elektrochemiezellen-Überwachungsvorrichtung, vorzugsweise die optische Sensoreinheit eine Auswerteeinheit, welche dazu vorgesehen ist, die durch den Sensor ermittelten Rohdaten zu analysieren und daraus den Funktionsparameter zu ermitteln. Insbesondere ist die Auswerteeinheit zu einer Bilderkennung und/oder Bildverarbeitung der empfangenen optischen Sensordaten vorgesehen.

Ferner wird vorgeschlagen, dass das Anzeigemodul zumindest ein weiteres Anzeigeelement oder eine Mehrzahl an weiteren Anzeigeelementen umfasst. Dadurch kann vorteilhaft eine Effizienz weiter verbessert werden, insbesondere indem die optische Sensoreinheit gleichzeitig Funktionsparameter einer Mehrzahl an Elektrochemiezellen überwachen kann. Insbesondere sind das Anzeigeelement und das weitere Anzeigeelement / die Mehrzahl an weiteren Anzeigeelementen durch das Anzeigemodul relativ zueinander angeordnet und/oder ausgerichtet. Insbesondere ist jedes Anzeigeelement dazu vorgesehen, zumindest eine Information über zumindest einen Funktionsparameter zumindest einer Elektrochemiezelle in Form elektromagnetischer Strahlung auszugeben. Vorzugsweise geben verschiedene Anzeigeelemente verschiedene Funktionsparameter aus. Vorzugsweise geben verschiedene Anzeigeelemente Funktionsparameter verschiedener Elektrochemiezellen aus. Zudem ist denkbar, dass eine Elektrochemieeinheit mehrere Anzeigemodule aufweist, welche von einer gemeinsamen optischen Sensoreinheit oder von unterschiedlichen optischen Sensoreinheiten überwacht werden. Beispielsweise kann ein Anzeigemodul mehr als 4, mehr als 6, mehr als 10 oder auch mehr als 20 einzelne Anzeigeelemente aufweisen.

Wenn jedes Anzeigeelement genau einer einzelnen Elektrochemiezelle zugeordnet ist, und insbesondere jeweils dazu vorgesehen ist, eine Information über den Funktionsparameter genau dieser Elektrochemiezelle auszusenden, kann vorteilhaft eine einfache, effiziente und zuverlässige Überwachung sichergestellt werden. Insbesondere ist das Anzeigeelement einer ersten Elektrochemiezelle einer Elektrochemieeinheit zugeordnet, während das weitere Anzeigeelement einer zweiten Elektrochemiezelle der Elektrochemieeinheit zugeordnet ist, die verschieden ist von der ersten Elektrochemiezelle. Vorzugsweise ist das Anzeigeelement einer ersten Elektrolysezelle eines Elektrolysestacks zugeordnet, während das weitere Anzeigeelement einer zweiten Elektrolysezelle desselben Elektrolysestacks zugeordnet ist, die verschieden ist von der ersten Elektrolysezelle.

Alternativ dazu ist denkbar, dass jedes Anzeigeelement einer Gruppe von Elektrochemiezellen zugeordnet ist und insbesondere jeweils dazu vorgesehen ist, eine Information über den Funktionsparameter genau dieser Gruppe von Elektrochemiezellen auszusenden. Die Gruppe kann beispielsweise zwei, drei, vier, fünf, sechs, sieben, acht oder mehr als acht Elektrochemiezellen umfassen. Vorzugsweise umfasst die Gruppe in einer Elektrochemieeinheit benachbart angeordnete Elektrochemiezellen.

Außerdem wird vorgeschlagen, dass das Anzeigeelement und das weitere Anzeigeelement, insbesondere eine die Zahl zwei übersteigende Mehrzahl an Anzeigeelementen, relativ zu einer horizontalen Linie und/oder relativ zu einer vertikalen Linie mit einem Versatz zueinander angeordnet sind. Dadurch kann vorteilhaft eine einfache, sichere und/oder zuverlässige Zuordnung der Anzeigeelemente zu einzelnen Elektrochemiezellen, insbesondere durch die Auswerteeinheit ermöglicht werden. Der Versatz beträgt insbesondere zumindest 10%, vorzugsweise zumindest 20% und bevorzugt zumindest 30% einer Maximalerstreckung des Anzeigeelements parallel zu der horizontalen Linie und/oder zu der vertikalen Linie. Der Versatz beträgt insbesondere höchstens 200%, vorzugsweise höchstens 100% und bevorzugt höchstens 75% einer Maximalerstreckung des Anzeigeelements parallel zu der horizontalen Linie und/oder zu der vertikalen Linie.

Wenn alternativ dazu das Anzeigeelement und das weitere Anzeigeelement, insbesondere die die Zahl zwei übersteigende Mehrzahl an Anzeigeelementen, horizontal oder vertikal in einer linearen Reihe angeordnet sind, kann vorteilhaft eine hohe Kompaktheit des Anzeigemoduls erreicht werden. Dadurch kann vorteilhaft eine besonders hohe Informationsdichte, insbesondere pro optischer Sensoreinheit, erreicht werden.

Zusätzlich wird vorgeschlagen, dass die Information über den zumindest einen Funktionsparameter in einer Intensität und/oder in einem Spektrum der durch das jeweilige Anzeigeelement ausgegebenen elektromagnetischen Strahlung codiert ist. Dadurch kann vorteilhaft eine besonders genaue und/oder zuverlässige Ermittlung des Funktionsparameters ermöglicht werden. Insbesondere korreliert eine Intensität der ausgegebenen Strahlung, beispielsweise linear oder auf eine andere Weise, mit einem Wert des Funktionsparameters. Insbesondere ist jedem Intensitätswert der ausgegebenen Strahlung ein eindeutiger Wert des Funktionsparameters zuordenbar. Insbesondere korreliert eine Frequenz oder Wellenlänge der ausgegebenen Strahlung, beispielsweise linear oder auf eine andere Weise, mit einem Wert des Funktionsparameters. Insbesondere ist jeder Wellenlänge oder jeder Frequenz der ausgegebenen Strahlung ein eindeutiger Wert des Funktionsparameters zuordenbar. Alternativ oder zusätzlich ist denkbar, dass die Information über den zumindest einen Funktionsparameter oder eine davon verschiedene weitere Information in einer Blinkfrequenz oder in einer Blinkabfolge (vergleichbar zu einem Morse-Code) codiert ist.

Wenn der Funktionsparameter als eine Einzelzellspannung der, insbesondere zu dem Anzeigeelement, zugehörigen Elektrochemiezelle, insbesondere als eine Einzelzellspannung einer Elektrolysezelle eines Elektrolysestacks, ausgebildet ist, kann vorteilhaft eine Information über einen Betriebszustand, über eine Alterung und/oder über eine Funktionsfähigkeit einzelner Elektrochemiezellen auf einfache Weise ausgelesen werden. Vorzugsweise bildet das Anzeigemodul ein Muster / eine Matrix von Anzeigeelementen aus, aus welcher der Zustand aller Elektrochemiezellen der Elektrochemieeinheit auf einmal ("auf einen Blick") auslesbar ist. Insbesondere liegen die durch das Anzeigeelement angezeigten Einzelzellspannungen in einem Bereich zwischen etwa 1,5 V und 2,5 V.

Wenn außerdem das zumindest eine Anzeigeelement als eine LED (Light-Emitting Diode) ausgebildet ist, kann vorteilhaft eine hohe Effizienz, insbesondere hinsichtlich eines Bauraums, hinsichtlich Kosten und/oder hinsichtlich eines Energieverbrauchs erreicht werden. Zudem kann vorteilhaft eine einfache, präzise und insbesondere direkte Umsetzung einer Einzelzellspannung in eine Leuchtintensität des Anzeigeelements ermöglicht werden. Insbesondere sind alle Anzeigeelemente des Anzeigemoduls als LED ausgebildet. Insbesondere sind die LEDs des Anzeigemoduls zumindest im Wesentlichen identisch. Alternativ ist jedoch auch denkbar, dass unterschiedliche LEDs, beispielsweise unterschiedlich farbige LEDs, als Anzeigeelemente vorgesehen sind, wobei beispielsweise die unterschiedlichen Farben für das Anzeigen unterschiedlicher Funktionsparameter oder unterschiedlicher Informationen über denselben Funktionsparameter vorgesehen sein können. Die LED kann insbesondere Licht in einem sichtbaren Spektrum, in einem Infrarotspektrum und/oder in einem UV-Spektrum aussenden.

Wenn alternativ oder zusätzlich das zumindest eine Anzeigeelement als elektrischer Widerstand ausgebildet ist, welcher dazu vorgesehen ist, die Information über den zumindest einen Funktionsparameter der Elektrochemiezelle in Form von Wärmestrahlung auszugeben, kann vorteilhaft eine unsichtbare Signalübertragung ermöglicht werden. Vorteilhaft kann zudem eine kostengünstige Signalübertragung erreicht werden. Es ist denkbar, dass als LED und als elektrischer Widerstand ausgebildete Anzeigeelemente in einem gemeinsamen Anzeigemodul angeordnet sind oder dass als LED und als elektrischer Widerstand ausgebildete Anzeigeelemente in zwei voneinander getrennten Anzeigemodulen angeordnet sind, die beide der gleichen Elektrochemieeinheit zugeordnet sind. Insbesondere ist auch in diesem Fall die Information über den zumindest einen Funktionsparameter in einer Intensität und/oder in einem Spektrum der durch den elektrischen Widerstand ausgegebenen elektromagnetischen Strahlung codiert. Insbesondere kann in diesem Fall eine Wärmebildkamera zum Auslesen der Signale des Anzeigeelements vorgesehen sein.

Zusätzlich wird vorgeschlagen, dass die optische Sensoreinheit als eine Kamera ausgebildet ist, welche dazu vorgesehen ist, eine automatische Bilderkennung und/oder Bildverarbeitung durchzuführen und/oder welche mit einem externen Bilderkennungs- und Bildverarbeitungssystem verbunden ist. Dadurch kann vorteilhaft eine hohe Effizienz erreicht werden. Vorteilhaft kann eine hohe Präzision, Zuverlässigkeit und/oder Bedienerfreundlichkeit erreicht werden. Insbesondere ist die Kamera für eine Detektion von sichtbarem Licht vorgesehen, kann jedoch alternativ oder zusätzlich auch für infrarotes oder ultraviolettes Licht ausgelegt sein. Zudem ist denkbar, dass die Kamera als eine Multispektralkamera oder als eine Hyperspektralkamera ausgebildet ist. Insbesondere kann die Kamera ein internes Bilderkennungs- und Bildverarbeitungssystem umfassen oder mit dem externen Bilderkennungs- und Bildverarbeitungssystem in Kommunikation stehen. Das Bilderkennungs- und Bildverarbeitungssystem umfasst insbesondere einen Speicher zu einem Speichern der erfassten Bilddaten, ein Computerprogramm zur Bearbeitung/Analyse der erfassten Bilddaten und einen Prozessor zur Ausführung des Computerprogramms. Insbesondere ist das Bilderkennungs- und Bildverarbeitungssystem dazu vorgesehen, aus der Farbe und/oder der Helligkeit der einzelnen Anzeigeelemente die jeweilige Information über den zumindest einen Funktionsparameter der Elektrochemiezelle auszulesen. Insbesondere ist das Bilderkennungs- und Bildverarbeitungssystem dazu vorgesehen, jedem der Anzeigeelemente eine Elektrochemiezelle oder eine Gruppe von Elektrochemiezellen präzise zuzuordnen. Unter "vorgesehen" soll insbesondere speziell programmiert, ausgelegt und/oder ausgestattet verstanden werden. Darunter, dass ein Objekt zu einer bestimmten Funktion vorgesehen ist, soll insbesondere verstanden werden, dass das Objekt diese bestimmte Funktion in zumindest einem Anwendungs- und/oder Betriebszustand erfüllt und/oder ausführt. Zur Bilderkennung können verschiedene dem Fachmann bekannte Auswertealgorithmen eingesetzt werden.

Ferner wird ein Elektrochemiezellen-Überwachungssystem mit der Elektrochemiezellen-Überwachungsvorrichtung und mit der, eine Mehrzahl an Elektrochemiezellen, insbesondere Elektrolysezellen, Brennstoffzellen oder Batteriezellen, aufweisenden Elektrochemieeinheit, insbesondere einem Elektrolysestack, einem Brennstoffzellenstapel oder einer Batterie, vorgeschlagen. Dadurch kann vorteilhaft eine hohe Effizienz erreicht werden, insbesondere hinsichtlich Kosten und/oder Materialbedarf.

Wenn das Anzeigemodul an der Elektrochemieeinheit angeordnet ist, kann vorteilhaft eine einfache Zuordnung von erfassten Informationen ermöglicht werden. Zudem kann vorteilhaft ein Materialbedarf, insbesondere ein Kabelbedarf gering gehalten werden.

Wenn jedoch alternativ das Anzeigemodul getrennt und beabstandet von der Elektrochemieeinheit angeordnet ist, kann vorteilhaft eine gleichzeitige Überwachung einer besonders großen Zahl an Elektrochemieeinheiten, insbesondere mit nur einer geringen Zahl an Kameras, ermöglicht werden. Beispielsweise kann das Anzeigemodul einer Elektrochemieeinheit, insbesondere zusammen mit weiteren Anzeigemodulen anderer Elektrochemieeinheiten an einem zentralen Ort einer Anlage angeordnet sein. Alternativ könnte das Anzeigemodul zudem mit Lichtwellenleitern ausgestattet sein, die das Licht der Anzeigeelemente an einen von der Elektrochemieeinheit getrennten und beabstandet von der Elektrochemieeinheit angeordneten Ort übertragen. Zudem ist denkbar, dass die Anzeigeelemente erst ab einem Überschreiten eines Grenzwerts und/oder erst ab einem Unterschreiten eines Grenzwerts überhaupt elektromagnetische Strahlung emittieren.

Außerdem wird vorgeschlagen, dass das Elektrochemiezellen-Überwachungssystem zumindest eine weitere Elektrochemieeinheit, insbesondere einen weiteren Elektrolysestack, einen weiteren Brennstoffzellenstapel oder eine weitere Batterie, mit zumindest einem weiteren Anzeigemodul aufweist, wobei die optische Sensoreinheit dazu vorgesehen ist, zeitgleich oder nacheinander die elektromagnetischen Strahlungen von Anzeigeelementen des Anzeigemoduls der Elektrochemieeinheit und des weiteren Anzeigemoduls der weiteren Elektrochemieeinheit zu detektieren und aus den detektierten elektromagnetischen Strahlungen die Informationen über die Funktionsparameter der einzelnen Elektrochemiezellen der Elektrochemieeinheit und der weiteren Elektrochemieeinheit gleichzeitig und/oder sukzessive auszulesen. Dadurch kann vorteilhaft eine besonders hohe Effizienz erreicht werden. Insbesondere sind die Anzeigemodule der Elektrochemieeinheit und zumindest der weiteren Elektrochemieeinheit derart angeordnet, dass eine einzelne Kamera, ggf. unter Einbeziehung einer Schwenkung der Kamera, beide Anzeigemodule auslesen kann. Insbesondere sind mehr als zwei Elektrochemieeinheiten, vorzugsweise Anzeigemodule von mehr als zwei Elektrochemieeinheiten, in einem gemeinsamen Sichtfeld einer einzelnen Kamera angeordnet.

Des Weiteren wird vorgeschlagen, dass zumindest die Elektrochemieeinheit zumindest einen Kalibrationsbetriebsmodus aufweist, welcher dazu vorgesehen ist, einen bekannten Kalibrationsfunktionsparameter an die Elektrochemiezellen der Elektrochemieeinheit anzulegen, wobei der bekannte Kalibrationsfunktionsparameter eine von Null verschiedene Schutzspannung im Aus-Zustand der Elektrochemieeinheit oder eine, von einem im Vergleich zu einem Standard-Betriebsstrom geringen Anfahrtsstrom/Abschaltstrom beim Starten und/oder beim Stoppen der Elektrochemieeinheit erzeugte, von Null verschiedene Anfahrts- und/oder Abschaltspannung ist. Dadurch kann vorteilhaft eine hohe Genauigkeit erreicht werden, insbesondere auch über längere Betriebszeiträume. Insbesondere ist der bekannte Kalibrationsfunktionsparameter, insbesondere die Schutzspannung, die Anfahrtsspannung und/oder die Abschaltspannung, zeitlich konstant. Beispielsweise könnte der bekannte Kalibrationsfunktionsparameter konstant bei einem Spannungswert zwischen 1,42 V und 1,55 V liegen. Wenn der konstante Spannungswert im Kalibrationsbetriebsmodus bekannt ist, kann über die Ermittlung der Intensität oder der Spektralfarbe in dem Kalibrationsbetriebsmodus der spannungsabhängige Intensitätsverlauf und/oder der spannungsabhängige Farbverlauf jedes einzelnen Anzeigeelements kalibriert werden. Alternativ oder zusätzlich ist denkbar, dass zur Verbesserung der Kalibration ein zweiter bekannter Kalibrationsfunktionsparameter an die Elektrochemiezellen der Elektrochemieeinheit angelegt wird. Beispielsweise könnten dazu die Schutzspannung, die Anfahrtsspannung und/oder die Abschaltspannung periodisch variiert werden oder jeweils unterschiedliche Werte annehmen. Bei einem Elektrolyseur liegt die Schutzspannung vorzugsweise in der Nähe (z.B. weniger als 10% entfernt), aber unterhalb einer für eine Elektrolyse nötigen minimalen Betriebsspannung.

Zusätzlich wird ein Verfahren zur Überwachung einer Elektrochemiezelle, insbesondere mittels der Elektrochemiezellen-Überwachungsvorrichtung vorgeschlagen, wobei zumindest eine Information über zumindest einen Funktionsparameter der Elektrochemiezelle in Form elektromagnetischer Strahlung ausgegeben wird, wobei in zumindest einem Verfahrensschritt die ausgegebene elektromagnetische Strahlung von einer, insbesondere getrennt und beabstandet von der Elektrochemiezelle angeordneten, optischen Sensoreinheit detektiert wird und wobei in zumindest einem weiteren Verfahrensschritt aus der detektierten elektromagnetischen Strahlung zumindest die Information über den zumindest einen Funktionsparameter der Elektrochemiezelle ausgelesen wird. Dadurch kann vorteilhaft eine hohe Effizienz erreicht werden, insbesondere hinsichtlich Kosten und/oder Materialbedarf.

Außerdem wird in diesem Zusammenhang ein Verfahren zur Kalibration des Elektrochemiezellen-Überwachungssystems vorgeschlagen, wobei eine von Null verschiedene Schutzspannung im Aus-Zustand der Elektrochemieeinheit oder eine von Null verschiedene Anfahrtsspannung/Ausschaltspannung, die von einem im Vergleich zu einem Standard-Betriebsstrom geringen Anfahrtsstrom/Ausschaltstrom beim Starten/Stoppen der Elektrochemieeinheit erzeugt wird, für eine Kalibration des ausgelesenen Funktionsparameters verwendet wird. Dadurch kann vorteilhaft eine hohe Genauigkeit der Überwachung der Elektrochemiezellen sichergestellt werden, insbesondere auch über längere Betriebszeiträume.

Die erfindungsgemäße Elektrochemiezellen-Überwachungsvorrichtung, das erfindungsgemäße Elektrochemiezellen-Überwachungssystem und das erfindungsgemäße Verfahren sollen hierbei nicht auf die oben beschriebene Anwendung und Ausführungsform beschränkt sein. Insbesondere kann die erfindungsgemäße Elektrochemiezellen-Überwachungsvorrichtung, das erfindungsgemäße Elektrochemiezellen-Überwachungssystem und das erfindungsgemäße Verfahren zu einer Erfüllung einer hierin beschriebenen Funktionsweise eine von einer hierin genannten Anzahl von einzelnen Elementen, Bauteilen und Einheiten abweichende Anzahl aufweisen.

### Zeichnungen

Weitere Vorteile ergeben sich aus der folgenden Zeichnungsbeschreibung. In den Zeichnungen sind zwei Ausführungsbeispiele der Erfindung dargestellt. Die Zeichnungen, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1a: eine schematische Darstellung eines Elektrochemiezellen-Überwachungssystems mit einer Elektrochemiezellen-Überwachungsvorrichtung,
- Fig. 1b: eine schematische Darstellung des Elektrochemiezellen-Überwachungssystems mit einer alternativen Anordnung seiner Komponenten,
- Fig. 2: einen Ausschnitt einer schematischen Vorderansicht einer einzelnen Elektrochemieeinheit mit einem Anzeigemodul des Elektrochemiezellen-Überwachungssystems,
- Fig. 3: ein schematisches Ablaufdiagramm eines Verfahrens zur Überwachung von Elektrochemiezellen mittels der Elektrochem iezellen-Überwachungsvorrichtung,
- Fig. 4: ein schematisches Ablaufdiagramm eines Verfahrens zur Kalibration des Elektrochemiezellen-Überwachungssystems und
- Fig. 5: einen Ausschnitt einer schematischen Vorderansicht einer einzelnen Elektrochemieeinheit mit einem alternativen Anzeigemodul des Elektrochemiezellen-Überwachungssystems.

### Beschreibung der Ausführungsbeispiele

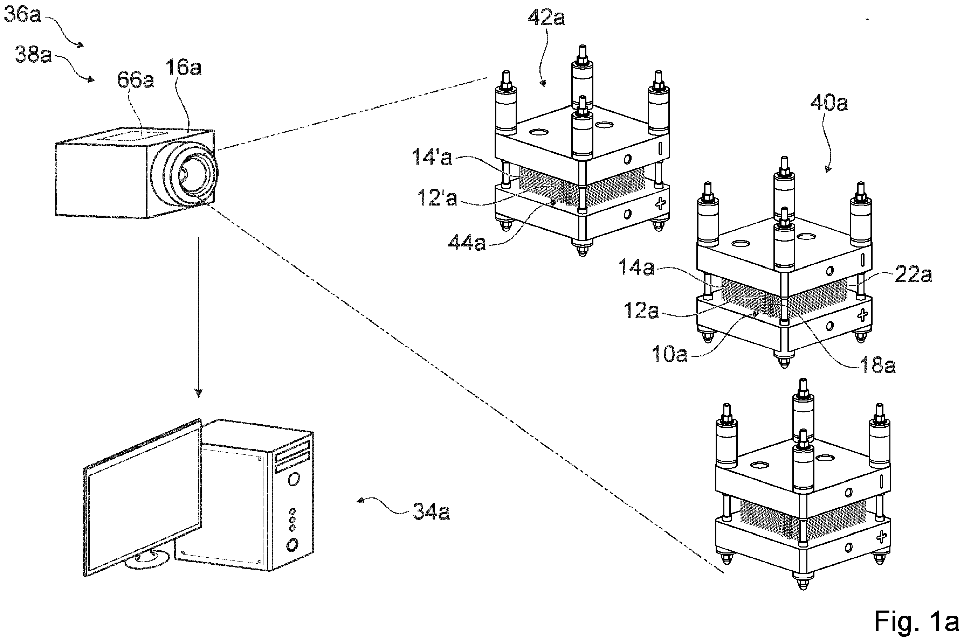

Die Fig. 1a zeigt eine schematische Darstellung eines Elektrochemiezellen-Überwachungssystems 36a. Das Elektrochemiezellen-Überwachungssystem 36a weist eine Elektrochemiezellen-Überwachungsvorrichtung 38a auf. Die Elektrochemiezellen-Überwachungsvorrichtung 38a ist als eine Elektrolysezellen-Überwachungsvorrichtung ausgebildet. Alternativ könnte die Elektrochemiezellen-Überwachungsvorrichtung 38a auch als Brennstoffzellen-Überwachungsvorrichtung und/oder als Batteriezellenüberwachungsvorrichtung ausgebildet sein. Die Elektrochemiezellen-Überwachungsvorrichtung 38a weist eine Elektrochemieeinheit 40a auf. Die Elektrochemiezellen-Überwachungsvorrichtung 38a weist zumindest eine weitere Elektrochemieeinheit 42a auf. Die Elektrochemieeinheit 40a und die weitere Elektrochemieeinheit 42a sind zumindest im Wesentlichen identisch zueinander ausgebildet, könnten aber auch verschieden zueinander ausgebildet sein. Die Elektrochemieeinheiten 40a, 42a sind jeweils als Elektrolysestacks, insbesondere in einer dem Fachmann aus dem Stand der Technik bekannten Art, ausgebildet. Die Elektrolysestacks bilden Teile einer gemeinsamen Elektrolyseanlage aus. Die Elektrolysestacks sind im vorliegenden Fall als dem Fachmann bekannte Polymerelektrolytmembran-Elektrolysestacks ausgebildet. Alternativ könnte zumindest ein Teil der Elektrochemieeinheiten 40a, 42a auch als ein anderer Elektrolyseur-Typ, wie u.a. beispielsweise ein Anion-Exchange-Membrane-Elektrolyseur (AEM), als Brennstoffzellenstapel oder Batterien ausgebildet sein. Die Elektrochemieeinheiten 40a, 42a umfassen jeweils eine Mehrzahl an Elektrochemiezellen 14a, 22a, 24a. Die Elektrochemiezellen 14a, 22a, 24a sind als Elektrolysezellen des Elektrolysestacks ausgebildet. Alternativ könnten die Elektrochemiezellen 14a, 22a, 24a auch Brennstoffzellen eines Brennstoffzellenstapels oder Batteriezellen einer Batterie ausbilden.

Die Elektrochemiezellen-Überwachungsvorrichtung 38a weist ein Anzeigemodul 10a auf. Das Anzeigemodul 10a ist an der Elektrochemieeinheit 40a angeordnet. Die Elektrochemiezellen-Überwachungsvorrichtung 38a weist ein weiteres Anzeigemodul 44a auf. Das weitere Anzeigemodul 44a ist an der weiteren Elektrochemieeinheit 42a angeordnet. Das Anzeigemodul 10a und das weitere Anzeigemodul 44a umfassen jeweils eine Mehrzahl an Anzeigeelementen 12a, 18a, 20a. Die Anzeigeelemente 12a, 18a, 20a sind als LEDs ausgebildet. Alternativ könnten die Anzeigeelemente 12a, 18a, 20a auch als elektrische Widerstände ausgebildet sein. Die Anzeigeelemente 12a, 18a, 20a sind dazu vorgesehen, zumindest eine Information über zumindest einen Funktionsparameter genau einer Elektrochemiezelle 14a, 22a, 24a in Form elektromagnetischer Strahlung auszugeben. Dabei ist jedes der Anzeigeelemente 12a, 18a, 20a jeweils genau einer Elektrochemiezelle 14a, 22a, 24a zugeordnet. Der Funktionsparameter ist dann als genau eine Einzelzellspannung der zugehörigen Elektrochemiezelle 14a, 22a, 24a ausgebildet. Alternativ könnten die Anzeigeelemente 12a, 18a, 20a auch dazu vorgesehen sein, zumindest eine Information über zumindest einen Funktionsparameter einer mehrere Elektrochemiezellen 14a, 22a, 24a umfassenden definierten Gruppe von Elektrochemiezellen 14a, 22a, 24a gemeinsam in Form elektromagnetischer Strahlung auszugeben. Dabei wäre jedes der Anzeigeelemente 12a, 18a, 20a jeweils genau einer definierten Gruppe von Elektrochemiezellen 14a, 22a, 24a zugeordnet. Der Funktionsparameter ist dann als eine Summe von Einzelzellspannung der der Gruppe zugehörigen Elektrochemiezellen 14a, 22a, 24a ausgebildet. In dem Fall der LED-Anzeigeelemente 12a, 18a, 20a ist die Information über den zumindest einen Funktionsparameter in einer Intensität und/oder in einem Spektrum der durch das jeweilige LED-Anzeigeelement 12a, 18a, 20a ausgegebenen elektromagnetischen Strahlung codiert. In dem Fall der als elektrischer Widerstand ausgebildeten Anzeigeelemente 12a, 18a, 20a ist die Information über den zumindest einen Funktionsparameter in einer Intensität und/oder in einem Spektrum der durch das jeweilige Anzeigeelement 12a, 18a, 20a ausgegebenen Wärmestrahlung codiert.

Die Elektrochemiezellen-Überwachungsvorrichtung 38a weist eine optische Sensoreinheit 16a auf. Die optische Sensoreinheit 16a ist getrennt und beabstandet von dem Anzeigemodul 10a angeordnet. Die optische Sensoreinheit 16a ist dazu vorgesehen, die elektromagnetische Strahlung zumindest des Anzeigeelements 12a zu detektieren und aus der detektierten elektromagnetischen Strahlung zumindest die Information über den zumindest einen Funktionsparameter der Elektrochemiezelle 14a auszulesen. Die optische Sensoreinheit 16a ist als eine Kamera ausgebildet. Die Kamera ist dazu vorgesehen, eine automatische Bilderkennung und/oder Bildverarbeitung der die Anzeigemodule 10a, 44a darstellenden erfassten Bilder durchzuführen. Die Kamera weist eine Auswerteeinheit 66a auf. Die Auswerteeinheit 66a ist als ein Computersystem mit Prozessor und Speicher und Auswertesoftware ausgebildet. Die Auswerteeinheit 66a ist zur Durchführung der Bilderkennung und/oder Bildverarbeitung der erfassten Bilder vorgesehen. Alternativ kann das Elektrochemiezellen-Überwachungssystem 36a ein externes Bilderkennungs- und Bildverarbeitungssystem 34a aufweisen. In diesem Fall ist die Kamera mit dem externen Bilderkennungs- und Bildverarbeitungssystem 34a verbunden und übermittelt die erfassten Bilder der Anzeigemodule 10a, 44a an das externe Bilderkennungs- und Bildverarbeitungssystem 34a zur Analyse und Auswertung.

Die optische Sensoreinheit 16a ist dazu vorgesehen, zeitgleich oder nacheinander die elektromagnetischen Strahlungen von Anzeigeelementen 12a, 12'a, 18a, 20a des Anzeigemoduls 10a der Elektrochemieeinheit 40a und des weiteren Anzeigemoduls 44a der weiteren Elektrochemieeinheit 42a zu detektieren und aus den detektierten elektromagnetischen Strahlungen die Informationen über die Funktionsparameter der einzelnen Elektrochemiezellen 14a, 14'a, 22a der Elektrochemieeinheit 40a und der weiteren Elektrochemieeinheit 42a gleichzeitig und/oder sukzessive auszulesen.

Die Elektrochemieeinheit 40a, 42a weist zumindest einen Kalibrationsbetriebsmodus auf. Der Kalibrationsbetriebsmodus ist dazu vorgesehen, einen bekannten Kalibrationsfunktionsparameter an die überwachten Elektrochemiezellen 14a, 22a, 24a der Elektrochemieeinheit 40a, 42a anzulegen. Der bekannte Kalibrationsfunktionsparameter ist als eine von Null verschiedene Schutzspannung im Aus-Zustand der Elektrochemieeinheit 40a, 42a ausgebildet. Alternativ oder zusätzlich kann der Kalibrationsfunktionsparameter auch als eine, von einem im Vergleich zu einem Standard-Betriebsstrom geringen Anfahrtsstrom/Abschaltstrom beim Starten und/oder beim Stoppen der Elektrochemieeinheit 40a, 42a erzeugte und von Null verschiedene Anfahrts- und/oder Abschaltspannung ausgebildet sein.

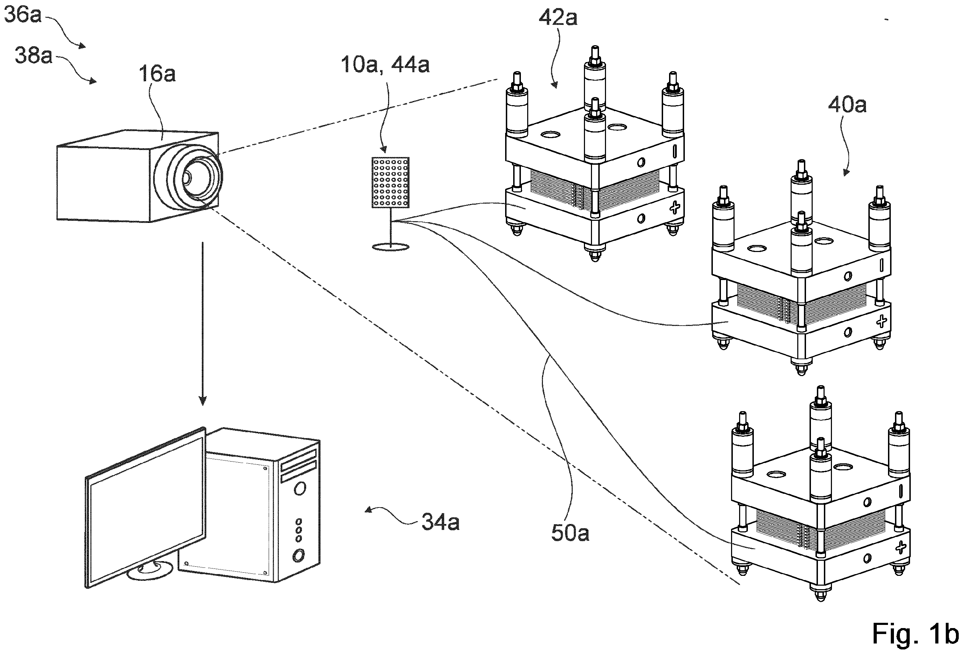

Die Fig. 1b zeigt eine schematische Darstellung des Elektrochemiezellen-Überwachungssystems 36a mit einer alternativen Anordnung der Komponenten. Die Anzeigemodule 10a, 44a sind in dieser alternativen Konfiguration getrennt und beabstandet von den Elektrochemieeinheiten 40a, 42a angeordnet. Die Anzeigemodule 10a, 44a sind mit Kabeln 50a mit den Elektrochemieeinheiten 40a, 42a verbunden. Die Anzeigemodule 10a, 44a sind zu einem gemeinsamen Anzeigemodul zusammengefasst. Über die Kabel 50a werden die Spannungen von den jeweiligen Elektrochemiezellen 14a, 22a, 24a an die Anzeigeelemente 12a, 18a, 20a der Anzeigemodule 10a, 44a übertragen. Die Anzeigemodule 10a, 44a sind dadurch zentral überwachbar.

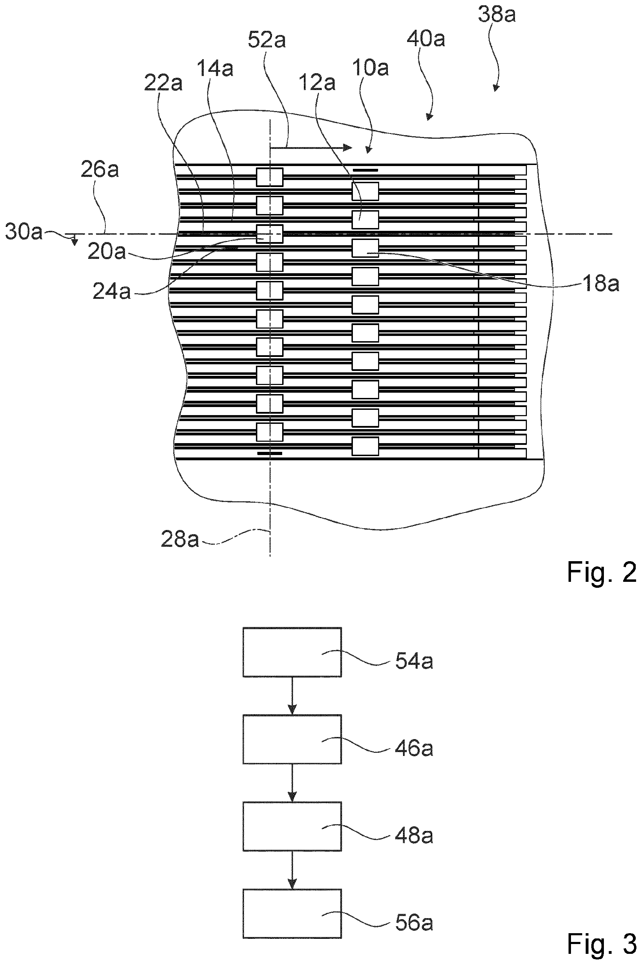

Die Fig. 2 zeigt einen Ausschnitt einer schematischen Vorderansicht einer einzelnen Elektrochemieeinheit 40a mit dem die Anzeigeelemente 12a, 18a, 20a aufweisenden Anzeigemodul 10a in einer vorgesehenen Aufstellposition. Das Anzeigeelement 12a und die weiteren Anzeigeelemente 18a, 20a sind relativ zu einer zu der vorgesehenen Aufstellposition horizontalen Linie 26a mit einem Versatz 30a zueinander angeordnet. Das Anzeigeelement 12a und die weiteren Anzeigeelemente 18a, 20a können zudem relativ zu einer zu der Aufstellposition vertikalen Linie 28a mit einem Versatz 52a zueinander angeordnet sein. In der in der Fig. 2 beispielhaft dargestellten Ausgestaltung sind nur das Anzeigeelement 12a und eines der weiteren Anzeigeelemente 18a mit einem Versatz 52a relativ zu der vertikalen Linie 28a angeordnet. Das Anzeigeelement 12a und das andere weitere Anzeigeelement 20a sind zueinander ohne Versatz relativ zu der vertikalen Linie 28a angeordnet. Die Versätze 30a, 52a sind jeweils kleiner als die Erstreckung der Anzeigeelemente 12a, 18a, 20a in der jeweils selben Richtung wie die Versätze 30a, 52a.

Die Fig. 3 zeigt ein schematisches Ablaufdiagramm eines Verfahrens zur Überwachung von Elektrochemiezellen 14a, 22a, 24a mittels der Elektrochemiezellen-Überwachungsvorrichtung 38a. In dem Verfahren wird zumindest eine Information über zumindest einen Funktionsparameter der Elektrochemiezelle 14a, 22a, 24a in Form elektromagnetischer Strahlung ausgegeben. In zumindest einem Betriebszustand fallen Spannungen an den Elektrochemiezellen 14a, 22a, 24a ab. Aus den abfallenden Spannungen können Funktionsparameter der jeweiligen Elektrochemiezellen und/oder Informationen über Funktionsparameter der jeweiligen Elektrochemiezellen 14a, 22a, 24a ausgelesen werden. Diese Spannungen werden an die den Elektrochemiezellen 14a, 22a, 24a zugeordneten Anzeigeelemente 12a, 18a, 20a weitergeleitet. In zumindest einem Verfahrensschritt 54a werden die Anzeigeelemente 12a, 18a, 20a mit den an den Elektrochemiezellen 14a, 22a, 24a abfallenden Spannungen betrieben. Dadurch werden die Anzeigeelemente 12a, 18a, 20a spannungsabhängig zum Leuchten gebracht oder erwärmt, d.h. die Anzeigeelemente 12a, 18a, 20a geben elektromagnetische Strahlung aus, in der der Funktionsparameter codiert ist. In zumindest einem Verfahrensschritt 46a wird die von den Anzeigeelementen 12a, 18a, 20a ausgegebene elektromagnetische Strahlung von der optischen Sensoreinheit 16a detektiert. In zumindest einem weiteren Verfahrensschritt 48a wird aus der detektierten elektromagnetischen Strahlung zumindest die Information über den zumindest einen Funktionsparameter der Elektrochemiezelle 14a, 22a, 24a ausgelesen. In dem Verfahrensschritt 48a werden die von der optischen Sensoreinheit 16a erfassten Bilddaten analysiert und ausgewertet. In dem Verfahrensschritt 48a wird eine Wellenlängenbestimmung und/oder eine Intensitätsbestimmung der von dem Anzeigemodul 10a erfassten Signale aus den Bilddaten ausgelesen und in den Funktionsparameter umgerechnet. In zumindest einem Verfahrensschritt 56a werden die ermittelten Funktionsparameter ausgegeben, beispielsweise mittels einer Bildschirmanzeige.

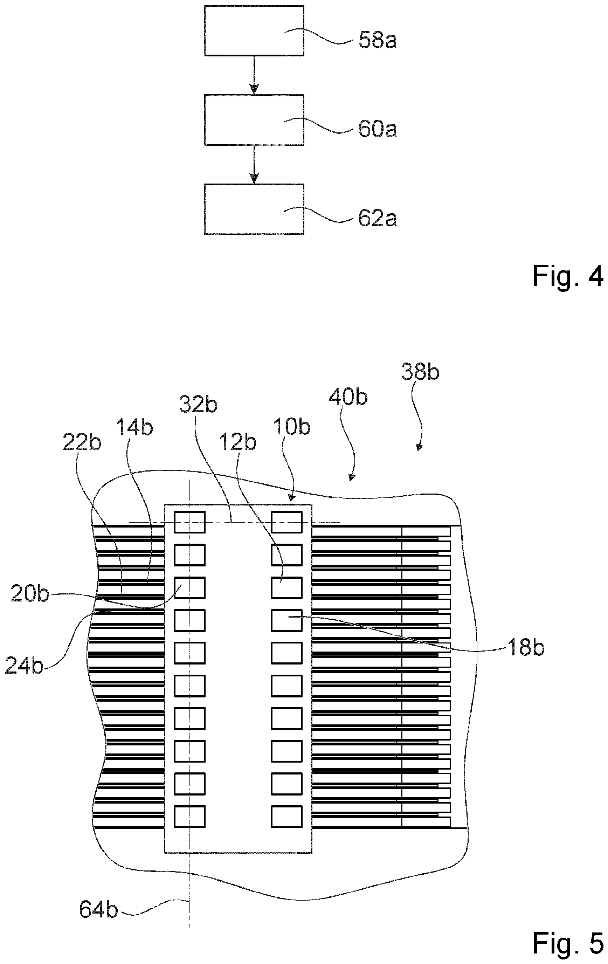

Die Fig. 4 zeigt ein schematisches Ablaufdiagramm eines Verfahrens zur Kalibration eines Elektrochemiezellen-Überwachungssystems 36a. In zumindest einem Verfahrensschritt 58a wird eine von Null verschiedene Schutzspannung im Aus-Zustand der Elektrochemieeinheit 40a oder eine von Null verschiedene Anfahrtsspannung, die von einem im Vergleich zu einem Standard-Betriebsstrom geringen Anfahrtsstrom beim Starten der Elektrochemieeinheit 40a erzeugt wird, oder eine von Null verschiedene Ausschaltspannung, die von einem im Vergleich zu einem Standard-Betriebsstrom geringen Ausschaltstrom beim Stoppen der Elektrochemieeinheit 40a erzeugt wird, an die Elektrochemiezellen 14a, 22a, 24a angelegt. Dadurch wird von den Anzeigeelementen 12a, 18a, 20a, die den Elektrochemiezellen 14a, 22a, 24a zugeordnet sind, jeweils ein Kalibrationssignal in Form elektromagneteischer Wellen ausgesandt. In zumindest einem Verfahrensschritt 60a werden die Kalibrationssignale von der optischen Sensoreinheit 16a erfasst. In zumindest einem Verfahrensschritt 62a werden die empfangenen Kalibrationssignale für eine Kalibration der ausgelesenen Funktionsparameter verwendet. In dem Verfahrensschritt 62a werden Auswertefunktionen des Bilderkennungs- und/oder Bildverarbeitungssystems 34a, die jeweils einzelnen Anzeigeelementen 12a, 18a, 20a zugeordnet sind, mittels der empfangenen Kalibrationssignale kalibriert.

In der Figur 5 ist ein weiteres Ausführungsbeispiel der Erfindung gezeigt. Die nachfolgenden Beschreibungen und die Zeichnungen beschränken sich im Wesentlichen auf die Unterschiede zwischen den Ausführungsbeispielen, wobei bezüglich gleich bezeichneter Bauteile, insbesondere in Bezug auf Bauteile mit gleichen Bezugszeichen, grundsätzlich auch auf die Zeichnungen und/oder die Beschreibung der anderen Ausführungsbeispiele, insbesondere der Figuren 1 bis 4, verwiesen werden kann. Zur Unterscheidung der Ausführungsbeispiele ist der Buchstabe a den Bezugszeichen des Ausführungsbeispiels in den Figuren 1 bis 4 nachgestellt. In dem Ausführungsbeispiel der Figur 5 ist der Buchstabe a durch den Buchstaben b ersetzt.

Die Fig. 5 zeigt einen Ausschnitt einer Vorderansicht einer einzelnen Elektrochemieeinheit 40b mit einem alternativen Anzeigemodul 10b. Das alternative Anzeigemodul 10b weist eine Mehrzahl an Anzeigeelementen 12b, 18b, 20b auf. Die Anzeigeelemente 12b, 18b, 20b sind horizontal und vertikal entlang linearen Reihen 32b, 64b angeordnet. Die Anzeigeelemente 12b, 18b, 20b einer horizontalen Reihe 32b sind im Wesentlichen frei von vertikalen Versätzen. Die Anzeigeelemente 12b, 18b, 20b einer vertikalen linearen Reihe 64b sind dabei im Wesentlichen frei von horizontalen Versätzen.

### Bezugszeichen

- 10: Anzeigemodul
- 12: Anzeigeelement
- 14: Elektrochemiezelle
- 16: optische Sensoreinheit
- 18: Weiteres Anzeigeelement
- 20: Weiteres Anzeigeelement
- 22: Elektrochemiezelle
- 24: Elektrochemiezelle
- 26: Horizontale Linie
- 28: Vertikale Linie
- 30: Versatz
- 32: Lineare Reihe
- 34: Bilderkennungs- und/oder Bildverarbeitungssystem
- 36: Elektrochemiezellen-Überwachungssystem
- 38: Elektrochemiezellen-Überwachungsvorrichtung
- 40: Elektrochemieeinheit
- 42: Weitere Elektrochemieeinheit
- 44: Weiteres Anzeigemodul
- 46: Verfahrensschritt
- 48: Verfahrensschritt
- 50: Kabel
- 52: Versatz
- 54: Verfahrensschritt
- 56: Verfahrensschritt
- 58: Verfahrensschritt
- 60: Verfahrensschritt
- 62: Verfahrensschritt
- 64: Reihe
- 66: Auswerteeinheit

## Patentansprüche

1. Elektrochemiezellen-Überwachungsvorrichtung (38a; 38b), insbesondere Elektrolysezellen-, Brennstoffzellen- und/oder Batteriezellenüberwachungsvorrichtung, mit zumindest einem Anzeigemodul (10a; 10b), welches zumindest ein Anzeigeelement (12a; 12b) aufweist, das dazu vorgesehen ist, zumindest eine Information über zumindest einen Funktionsparameter einer Elektrochemiezelle (14a; 14b) in Form elektromagnetischer Strahlung auszugeben, **gekennzeichnet durch** zumindest eine, insbesondere getrennt und beabstandet von dem Anzeigemodul (10a; 10b) angeordnete, optische Sensoreinheit (16a; 16b), welche dazu vorgesehen ist, die elektromagnetische Strahlung zumindest des Anzeigeelements (12a; 12b) zu detektieren und aus der detektierten elektromagnetischen Strahlung zumindest die Information über den zumindest einen Funktionsparameter der Elektrochemiezelle (14a; 14b) auszulesen.

2. Elektrochemiezellen-Überwachungsvorrichtung (38a; 38b) nach Anspruch 1, **dadurch gekennzeichnet, dass** das Anzeigemodul (10a; 10b) zumindest ein weiteres Anzeigeelement (18a; 18b) oder eine Mehrzahl an weiteren Anzeigeelementen (18a, 20a; 18b, 20b) umfasst.

3. Elektrochemiezellen-Überwachungsvorrichtung (38a; 38b) nach Anspruch 2, **dadurch gekennzeichnet, dass** jedes Anzeigeelement (12a, 18a, 20a; 12b, 18b, 20b) genau einer einzelnen Elektrochemiezelle (14a, 22a, 24a; 14b, 22b, 24b) zugeordnet ist, und insbesondere jeweils dazu vorgesehen ist, eine Information über den Funktionsparameter genau dieser Elektrochemiezelle (14a; 14b) auszusenden.

4. Elektrochemiezellen-Überwachungsvorrichtung (38a; 38b) nach Anspruch 2 oder 3, **dadurch gekennzeichnet, dass** das Anzeigeelement (12a) und das weitere Anzeigeelement (18a, 20a) relativ zu einer horizontalen Linie (26a) und/oder relativ zu einer vertikalen Linie (28a) mit einem Versatz (30a, 52a) zueinander angeordnet sind.

5. Elektrochemiezellen-Überwachungsvorrichtung (38a; 38b) nach einem der Ansprüche 2 oder 3, **dadurch gekennzeichnet, dass** das Anzeigeelement (12b) und das weitere Anzeigeelement (18b, 20b) horizontal oder vertikal in einer linearen Reihe (32b, 64b) angeordnet sind.

6. Elektrochemiezellen-Überwachungsvorrichtung (38a; 38b) nach einem der vorhergehenden Ansprüche, **dadurch gekennzeichnet, dass** die Information über den zumindest einen Funktionsparameter in einer Intensität und/oder in einem Spektrum der durch das jeweilige Anzeigeelement (12a, 18a, 20a; 12b, 18b, 20b) ausgegebenen elektromagnetischen Strahlung codiert ist.

7. Elektrochemiezellen-Überwachungsvorrichtung (38a; 38b) nach einem der vorhergehenden Ansprüche, **dadurch gekennzeichnet, dass** der Funktionsparameter als eine Einzelzellspannung der zugehörigen Elektrochemiezelle (14a, 22a, 24a; 14b, 22b, 24b) ausgebildet ist.

8. Elektrochemiezellen-Überwachungsvorrichtung (38a; 38b) nach einem der vorhergehenden Ansprüche, **dadurch gekennzeichnet, dass** das zumindest eine Anzeigeelement (12a, 18a, 20a; 12b, 18b, 20b) als eine LED ausgebildet ist.

9. Elektrochemiezellen-Überwachungsvorrichtung (38a; 38b) nach einem der Ansprüche 1 bis 7, **dadurch gekennzeichnet, dass** das zumindest eine Anzeigeelement (12a, 18a, 20a; 12b, 18b, 20b) als elektrischer Widerstand ausgebildet ist, welcher dazu vorgesehen ist, die Information über den zumindest einen Funktionsparameter der Elektrochemiezelle (14a, 22a, 24a; 14b, 22b, 24b) in Form von Wärmestrahlung auszugeben.

10. Elektrochemiezellen-Überwachungsvorrichtung (38a; 38b) nach einem der vorhergehenden Ansprüche, **dadurch gekennzeichnet, dass** die optische Sensoreinheit (16a; 16b) als eine Kamera ausgebildet ist, welche dazu vorgesehen ist, eine automatische Bilderkennung und/oder Bildverarbeitung durchzuführen und/oder welche mit einem externen Bilderkennungs- und Bildverarbeitungssystem (34a; 34b) verbunden ist.

11. Elektrochemiezellen-Überwachungssystem (36a; 36b) mit einer Elektrochemiezellen-Überwachungsvorrichtung (38a; 38b) nach einem der vorhergehenden Ansprüche und mit einer, eine Mehrzahl an Elektrochemiezellen (14a, 22a, 24a; 14b, 22b, 24b), insbesondere Elektrolysezellen, Brennstoffzellen oder Batteriezellen, aufweisenden Elektrochemieeinheit (40a; 40b), insbesondere einem Elektrolysestack, einem Brennstoffzellenstapel oder einer Batterie.

12. Elektrochemiezellen-Überwachungssystem (36a; 36b) nach Anspruch 11, **dadurch gekennzeichnet, dass** das Anzeigemodul (10a; 10b) an der Elektrochemieeinheit (40a; 40b) angeordnet ist.

13. Elektrochemiezellen-Überwachungssystem (36a; 36b) nach Anspruch 11, **dadurch gekennzeichnet, dass** das Anzeigemodul (10a; 10b) getrennt und beabstandet von der Elektrochemieeinheit (40a; 40b) angeordnet ist.

14. Elektrochemiezellen-Überwachungssystem (36a; 36b) nach einem der Ansprüche 11 bis 13, **gekennzeichnet durch** zumindest eine weitere Elektrochemieeinheit (42a; 42b), insbesondere einen weiteren Elektrolysestack, einen weiteren Brennstoffzellenstapel oder eine weitere Batterie, mit zumindest einem weiteren Anzeigemodul (44a; 44b), wobei die optische Sensoreinheit (16a; 16b) dazu vorgesehen ist, zeitgleich oder nacheinander die elektromagnetischen Strahlungen von Anzeigeelementen (12a, 12'a, 18a, 20a; 12b, 12'b, 18b, 20b) des Anzeigemoduls (10a; 10b) der Elektrochemieeinheit (40a; 40b) und des weiteren Anzeigemoduls (44a; 44b) der weiteren Elektrochemieeinheit (42a; 42b) zu detektieren und aus den detektierten elektromagnetischen Strahlungen die Informationen über die Funktionsparameter der einzelnen Elektrochemiezellen (14a, 14'a, 22a, 24a; 14b, 14'b, 22b, 24b) der Elektrochemieeinheit (40a; 40b) und der weiteren Elektrochemieeinheit (42a; 42b) gleichzeitig und/oder sukzessive auszulesen.

15. Elektrochemiezellen-Überwachungssystem (36a; 36b) nach einem der Ansprüche 11 bis 14, **dadurch gekennzeichnet, dass** zumindest die Elektrochemieeinheit (40a; 40b) zumindest einen Kalibrationsbetriebsmodus aufweist, welcher dazu vorgesehen ist, einen bekannten Kalibrationsfunktionsparameter an die Elektrochemiezellen (14a, 22a, 24a; 14b, 22b, 24b) der Elektrochemieeinheit (40a; 40b) anzulegen, wobei der bekannte Kalibrationsfunktionsparameter eine von Null verschiedene Schutzspannung im Aus-Zustand der Elektrochemieeinheit (40a; 40b) oder eine, von einem im Vergleich zu einem Standard-Betriebsstrom geringen Anfahrtsstrom/Abschaltstrom beim Starten und/oder beim Stoppen der Elektrochemieeinheit (40a; 40b) erzeugte, von Null verschiedene Anfahrts- und/oder Abschaltspannung ist.

16. Verfahren zur Überwachung einer Elektrochemiezelle (14a, 22a, 24a; 14b, 22b, 24b), insbesondere mittels einer Elektrochemiezellen-Überwachungsvorrichtung (38a; 38b) nach einem der Ansprüche 1 bis 10, wobei zumindest eine Information über zumindest einen Funktionsparameter der Elektrochemiezelle (14a, 22a, 24a; 14b, 22b, 24b) in Form elektromagnetischer Strahlung ausgegeben wird, **dadurch gekennzeichnet, dass** in zumindest einem Verfahrensschritt (46a; 46b) die ausgegebene elektromagnetische Strahlung von einer, insbesondere getrennt und beabstandet von der Elektrochemiezelle (14a, 22a, 24a; 14b, 22b, 24b) angeordneten, optischen Sensoreinheit (16a; 16b) detektiert wird und wobei in zumindest einem weiteren Verfahrensschritt (48a; 48b) aus der detektierten elektromagnetischen Strahlung zumindest die Information über den zumindest einen Funktionsparameter der Elektrochemiezelle (14a, 22a, 24a; 14b, 22b, 24b) ausgelesen wird.

17. Verfahren zur Kalibration eines Elektrochemiezellen-Überwachungssystems (36b; 36b) nach einem der Ansprüche 11 bis 15, **dadurch gekennzeichnet, dass** eine von Null verschiedene Schutzspannung im Aus-Zustand der Elektrochemieeinheit (40a; 40b) oder eine von Null verschiedene Anfahrtsspannung/Ausschaltspannung, die von einem im Vergleich zu einem Standard-Betriebsstrom geringen Anfahrtsstrom/Ausschaltstrom beim Starten/Stoppen der Elektrochemieeinheit (40a; 40b) erzeugt wird, für eine Kalibration des ausgelesenen Funktionsparameters verwendet wird.
